(19) Europäisches Patentamt
European Patent Office
Office européen des brevets

(11) EP 1 207 562 A2

(12) EUROPEAN PATENT APPLICATION

(43) Date of publication:
22.05.2002 Bulletin 2002/21

(51) Int Cl.⁷: H01L 29/732, H01L 21/331,
H01L 29/36, H01L 29/06

(21) Application number: 01126590.7

(22) Date of filing: 16.11.2001

(84) Designated Contracting States:
AT BE CH CY DE DK ES FI FR GB GR IE IT LI LU
MC NL PT SE TR
Designated Extension States:
AL LT LV MK RO SI

(30) Priority: 17.11.2000 JP 2000350796

(71) Applicant: NEC CORPORATION
Tokyo (JP)

(72) Inventor: Matsuoka, Akio
Yamagata-shi, Yamagata 990-0821 (JP)

(74) Representative: Baronetzky, Klaus, Dipl.-Ing.
Splanemann Reitzner
Baronetzky Westendorp
Patentanwälte
Rumfordstrasse 7
80469 München (DE)

(54) **Semiconductor device with heavily doped shallow region and process for fabricating the same**

(57) A process for fabricating semiconductor devices, comprises forming a surface film on the surface of a semiconductor substrate. The semiconductor substrate is doped with dopant through the surface film to form a dopant distribution layer. The doped surface film is removed, and then anneal is done to accomplish desired dopant profile of the box type.

# FIG.1

## Description

## BACKGROUND OF THE INVENTION

### 1. Field of the Invention

The present invention relates to a semiconductor device, and in particular to a heavily doped shallow region in a semiconductor substrate, and a process for fabricating the semiconductor device.

### 2. Description of the Related Art

Bipolar transistors are semiconductor devices in which both electrons and holes participate in the conduction process. Today's growing demand for bipolar transistors is to miniaturize the size and extend range of operation toward high frequencies. This demand may be met by a bipolar transistor, which possesses both high-frequency characteristic and high early voltage. Such a bipolar transistor must have shallow impurity distributions in various regions. In fabricating the various regions, it is difficult to make a shallow impurity distribution in the base region. What is required for the impurity distribution in the base region is heavy impurity concentration at an appropriate level in any depth not exceeding a predetermined limit. Further description on the impurity distribution is made, taking boron as an example of such impurity. In the following description, the term "profile or dopant profile or impurity profile or boron profile or arsenic profile" is used to mean the side view of an area defined by the concentration versus distance characteristic line of dopant (impurity) or boron and/or arsenic in cooperation with axes of a Cartesian coordinate system. Among the coordinate axes, the vertical axis represents the concentration of boron and/or arsenic and the horizontal axis the depth from the surface of substrate. Using the concentration versus distance characteristic, the profile of the box type or the rectangular profile represents a desired boron distribution in the base region. Expressing such desired boron distribution in plain words, the boron concentration is heavy at an appropriate level in any depth except the boundary, at which it drops rapidly.

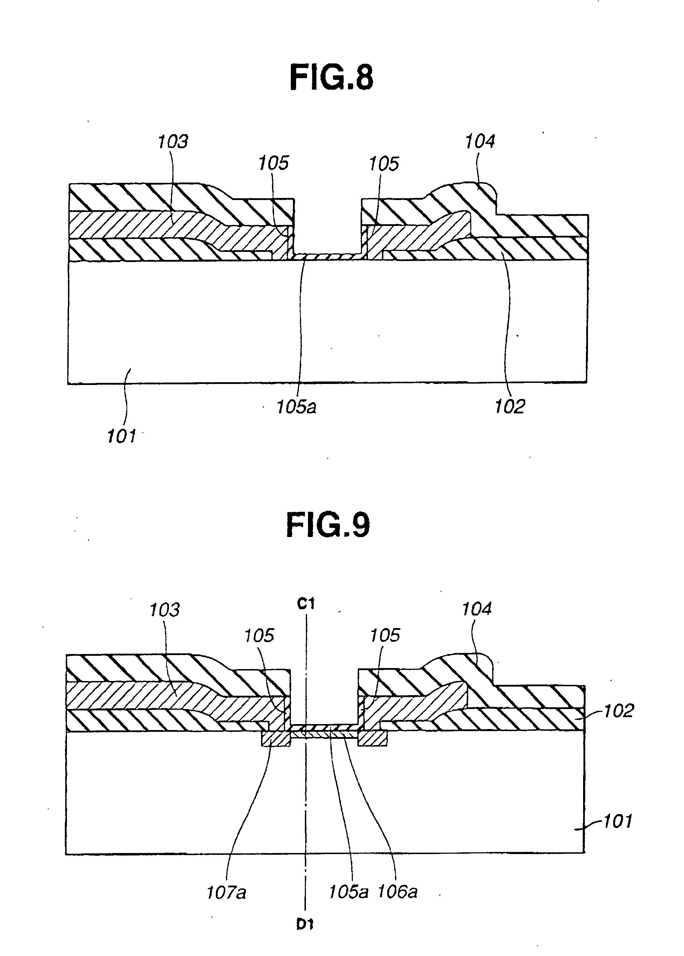

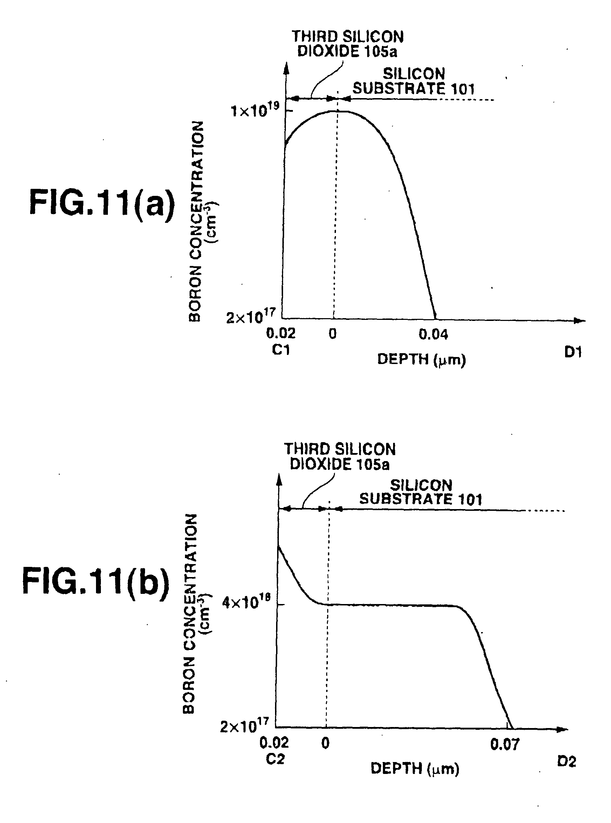

In order to form such a desired boron distribution in a base region, various processes have been developed by the assignee of the present invention. With reference to Figures 8-11(b), one such example is described. Figure 8 shows the layer structure including a silicon substrate 101 serving as a collector, a first silicon dioxide film 102, a first polysilicon film 103, a silicon nitride film 104, a second silicon dioxide 105, and a third silicon dioxide 105a. Doping operation is performed by implanting the molecular ion $^{49}(BF_2)^+$ into the silicon substrate 101 through a surface film such as the third silicon dioxide 105a. Ion energy is 3KeV, and ion dose is $1 \times 10^{15}/cm^2$. Ion implantation results in damaged region and lattice disorder in the silicon substrate, degrading semiconductor parameters such as mobility. To activate the implanted ions and to restore mobility, the lamp anneal is done within nitrogen atmosphere at annealing temperature of $900°C$ for 30 seconds. Figure 9 shows the layer structure after this initial lamp anneal, illustrating graft base 107a and intrinsic base 106a. Figure 11(a) shows the boron profile over the intrinsic base 106a along the line C1-D1 after the initial or first lamp anneal.

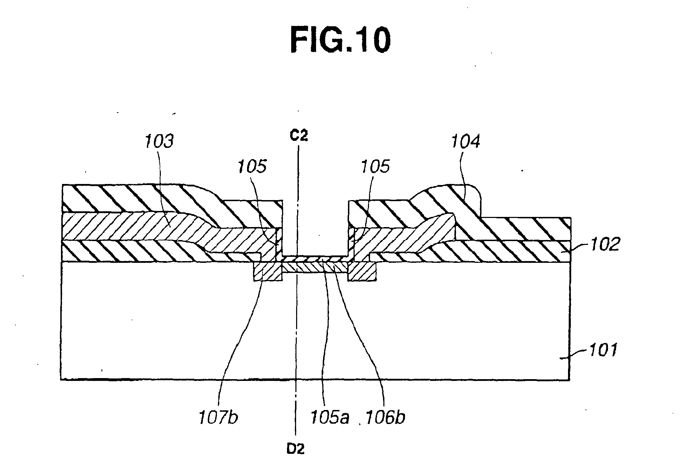

The first lamp anneal is followed by the second lamp anneal leaving the third silicon dioxide 105a as it is. This lamp anneal is done within oxygen atmosphere at annealing temperature of $900°C$ for 30 seconds. Figure 10 shows the layer structure after this second lamp anneal, illustrating graft base 107b and intrinsic base 106b. During this annealing, near the surface of the substrate 101, redistribution of boron into the third silicon dioxide 105a (segregation) takes place, causing a drop in boron concentration near the surface. Besides, electric field promotion effect, with which diffusion of impurities is accelerated at heavy concentrations, accelerates boron diffusion at concentrations greater than or equal to $3 \times 10^{18}/cm^3$ during annealing at $900°C$. Figure 11(b) shows the boron profile over the intrinsic base 106b along the line C2-D2 after the second lamp anneal. Comparing the profiles shown in Figures 11(a) and 11(b) with each other clearly reveals the effects due to segregation and accelerated boron diffusion during the second annealing within oxygen atmosphere.

With reference to Figure 11(b), it will be appreciated by those skilled in the art that the illustrated boron distribution shows various advantages. One of such advantages is a considerable increase in boron concentration level in any depth. Another advantage is an appreciable reduction in depth at which, after rapid drop, the boron concentration reaches a predetermined level. This predetermined level has been determined through experiments that were conducted in relation to the impurity (n-type conductive impurity) concentration in a collector region of the substrate 101 to provide high collector-emitter breakdown voltage and low collector resistance. In this example, the predetermined level is $2 \times 10^{17}/cm^3$, which is as high as the impurity concentration in the collector. The emitter is formed by diffusing arsenic into the surface portion of the boron-diffused base region.

With continuing reference to Figure 11(b), the illustrated boron distribution in the base region, however, is not yet satisfactory in that the depth at which the boron concentration drops down to the predetermined level of $2 \times 10^{17}/cm^3$ is deeper than a desired depth of $0.07 \ \mu m$. A need remains for restraining the depth at which the boron concentration drops down to the predetermined level of $2 \times 10^{17}/cm^3$ within the desired depth of $0.07 \ \mu m$. However, it would be difficult to achieve due to great diffusion coefficient of boron during annealing within oxygen atmosphere.

It is now described why the desired depth is

0.07 μm. The desired depth is empirically determined taking into account the emitter, which is formed by diffusing arsenic into the surface portion of the boron-diffused base region. In this example, the depth or width of the emitter is 0.02 μm, and the depth at which the boron distribution reaches the predetermined level of 2 x $10^{17}$/cm$^3$ is 0.07 μm + α. Thus, the depth or thickness of the base may be given by subtracting the depth (0.02 μm) of emitter from the depth (0.07 μm + α) of boron-diffused base region gives the width of base. In this case, the base has 0.05 μm + α. To provide a bipolar transistor with desired high-frequency characteristic, a base less than or equal to 0.05 μm thick is required. Accordingly, the desired depth at which the boron concentration reaches the predetermined level of 2 x $10^{17}$/cm$^3$ has been set equal to 0.07 μm. From the preceding description, it is now apparent to those skilled in the art that this proposed process is not satisfactory to provide a bipolar transistor with high-frequency characteristic by reducing the depth at which the boron concentration reaches the predetermined level of 2 x $10^{17}$/cm$^3$ at a depth less than 0.07 μm.

In an attempt to obtain the desired boron distribution in a base region, various processes are known in the art. One such example is described in Kawamoto et al: article entitled "Hitachi, Ltd., utilizes its all-round technology in fight, making it a chance to surface", Nikkei Microdevices, Nov. 1999, pp. 126-139. In Figure 19 and its descriptive portion in page 136, third column 3, lines 13-29, it is clearly stated that boron is doped into silicon by ion implantation at 3KeV, and by two-stage anneal follows to provide boron profile of the box type. The first anneal is done within nitrogen atmosphere with annealing temperature of 950°C for 1 minute, and then the second anneal is done within wet oxygen atmosphere at annealing temperature of 850°C for 5 minutes, providing the boron profile as shown in Figure 19. Scanning the boron profile shown in Figure 19 clearly shows that the boron concentration reaches the predetermined level of 2 x $10^{17}$/cm$^3$ at a depth of 0.07 μm. As mentioned before, diffusion coefficient of boron during annealing within wet oxygen atmosphere is great. It would be difficult using this known process to restrain the depth at which boron concentration drops down to the predetermined level of 2 x $10^{17}$/cm$^3$ within the depth of 0.07 μm.

As compared to the boron diffusion coefficient during annealing within oxygen atmosphere, the boron diffusion coefficient during annealing within nitrogen atmosphere is less. One example employing such anneal within nitrogen atmosphere is described in US-A 4,771,009 (Ueki) or JP-A 60-154670. In US-A 4,771,009, column 4 lines 20-36 clearly teaches annealing within nitrogen atmosphere at temperature of 1,000°C or less for diffusion of implanted boron ions to form a p-type base region and a p$^+$-type graft base region. Another example of anneal within nitrogen atmosphere is described in JP-A 4-87327. JP-A 4-87327 teaches implanting boron ions into a silicon substrate at 50 KeV with ion dose of 1 x $10^{15}$/cm$^2$, and then conducting anneal within nitrogen atmosphere at 1,000°C for 45 minutes. It appears that such anneals within nitrogen atmosphere result in deep boron profile remarkably different from the desired boron profile of the box type.

## SUMMARY OF THE INVENTION

An object of the present invention is to provide a semiconductor device having a heavily doped shallow region with the desired dopant profile of the box type mentioned above.

Another object of the present invention is to provide a process for fabricating such a semiconductor device.

According to one aspect of the present invention, there is provided a semiconductor device, comprising:

a semiconductor substrate having a collector region doped with a first dopant; and
a base region formed into the substrate and has a thickness, in depth direction, that is less than or equal to 0.05 μm, the base region being doped with a second dopant and having a dopant profile,
the dopant profile having dopant concentrations whose maximum level (N) is greater than 3.0 x $10^{18}$/cm$^3$ and less than 5.0 x $10^{18}$/cm$^3$,
over at least 60 % of the thickness of the base region, the difference between the dopant concentrations and the maximum level (N) falling in 10 % of the maximum level (N).
the thickness of the base region being the depth of a range where the dopant concentrations are greater than or equal to a dopant concentration of the first dopant of the collector region.

According to another aspect of the present invention, there is provided a process for fabricating semiconductor devices, comprising:

forming a surface film on the surface of a semiconductor substrate;
doping the semiconductor substrate with dopant through the surface film to form a dopant distribution layer;
removing the surface film doped with the dopant; and
annealing the semiconductor substrate after the removing of the surface film.

## BRIEF DESCRIPTION OF THE DRAWINGS

The foregoing and other objects, features and advantages of the invention will be apparent from the following more particular description of exemplary embodiments of the invention as illustrated in the accompanying drawings. The drawings are not necessarily scale, emphasis instead being placed upon illustrating the principles of the invention.

Figure 1 is an abbreviated schematic cross sectional view showing the layer structure of a semiconductor device in the form of a bipolar transistor fabricated by the process according to the present invention.

Figures 2 through 6 are a series of abbreviated schematic cross sectional views showing a sequence of process steps used in a preferred embodiment of the present invention.

Figure 7(a) shows a dopant (boron) profile across a surface film and a silicon substrate along the line A1-B1 through an intermediate structure shown in Figure 3, which intermediate structure is provided by implanting through the surface film to heavily dope the silicon substrate, and by annealing to repair damage and activate dopant.

Figure 7(b) shows a dopant (boron) profile across the silicon substrate along the line A2-B2 through an intermediate structure shown in Figure 4, which intermediate structure is provided by removing the surface film and by annealing to diffuse dopant out from the surface and to use electric field promotion effect for diffusing dopant deeply out of concentrations higher than a predetermined level of $3 \times 10^{18}/cm^3$, which predetermined level is provided during annealing at annealing temperature of 900°C.

Figure 7(c) shows dopant (boron and arsenic) profiles across the silicon substrate along the line A3-B3 through an intermediate structure shown in Figure 5, showing an emitter region enclosed by an intrinsic base region.

Figures 8 through 10 are a series of abbreviated schematic cross sectional views showing a sequence of process steps used in the before mentioned fabrication process proposed by the assignee of the present invention.

Figure 11(a) shows a dopant (boron) profile across a surface film and a silicon substrate along the line C1-D1 through an intermediate structure shown in Figure 9, which intermediate structure is provided by implanting through the surface film to heavily dope the silicon substrate, and by annealing to repair damage and activate dopant.

Figure 11(b) shows a dopant (boron) profile across the silicon substrate along the line C2-D2 through an intermediate structure shown in Figure 10, which intermediate structure is provided by leaving the surface film as it is and by annealing to diffuse dopant deeply out of the surface film and to use electric field promotion effect for diffusing dopant deeply out of concentrations higher than the predetermined level of $3 \times 10^{18}/cm^3$, which predetermined level is provided during annealing at annealing temperature of 900°C.

## DESCRIPTION OF THE PREFERRED EMBODIMENT

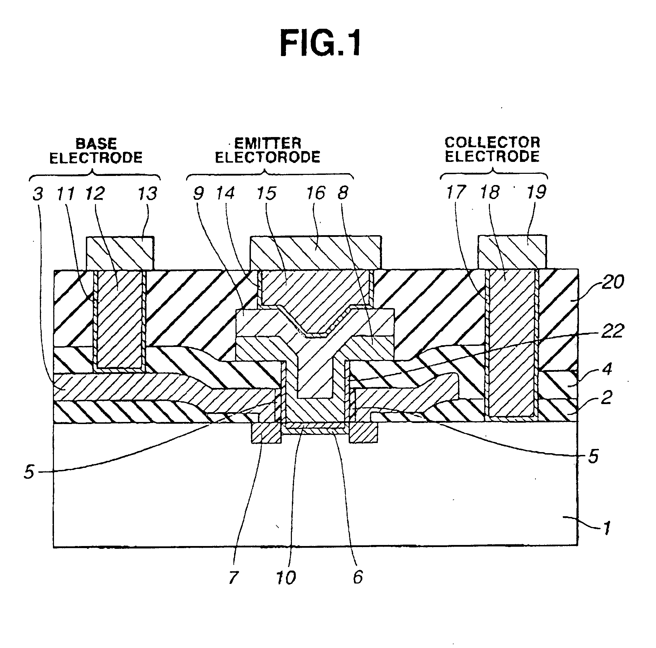

Referring to Figure 1, the illustrated semiconductor device is a bipolar transistor formed in a semiconductor substrate 1 of a first conduction type. The substrate 1 serves as a collector. Formed into the substrate 1 is a buried intrinsic base region 6 of a second conduction type. The base region 6 is formed into the substrate 1 by ion implantation doping. The second conduction type is the opposite conduction type to the first conduction type. Formed into the intrinsic base region 6 is a buried emitter region 10 of first conduction type. The emitter region 10 is formed into the intrinsic base region 6 by ion implantation doping. The collector or substrate 1. intrinsic base region 6, and emitter region 10 are routed electrically outwards via a collector electrode 19, a base electrode 13, and an emitter electrode 16, respectively.

The collector electrode 19 is in contact with a contact-making metal 18 enclosed by a barrier metal 17. The contact-making metal 18 is disposed in a vertical via or hole formed through an insulating layer 20, a silicon nitride layer 4, and a silicon dioxide layer 2. Via the barrier metal 17, the contact-making metal 18 is in contact with the upper side surface of the substrate 1. If desired, a collector electrode may constitute a metal layer on the lower side surface of the substrate 1.

The base electrode 13 is in contact with a contact-making metal 12 enclosed by a barrier metal 11. The contact-making metal 12 is disposed in a vertical via or hole formed through the insulating layer 20 and the silicon nitride layer 4. Via the barrier metal 11, the contact-making metal 12 is in contact with a polysilicon layer 3 between the silicon dioxide layer 2 and the silicon nitride layer 4. The polysilicon layer 3 is in contact with a graft base 7 through a vertical via or hole formed through the silicon dioxide layer 2. The graft base 7 of the second conduction type is formed into the substrate 1 by ion implantation doping in such a manner as to surround the intrinsic base region 6 in contact relationship. For electrical connection between the contact-making metal 12 and the graft base 7, the polysilicon layer 3 is doped with a dopant of the second conduction type.

The emitter electrode 16 is in contact with a contact-making metal 15 enclosed by a barrier metal 14. For making electrical connection between the contact-making metal 15 and the emitter region 10, two polysilicon generally T-like profiled elements 8 and 9, doped with a dopant of the first conduction type, are provided. The polysilicon T-like element 8 is disposed in a vertical via or hole formed through the polysilicon layer 3 and an aligned vertical via or hole formed through the silicon nitride layer 4. Electrically separating the polysilicon T-like element 8 from the polysilicon layer 3 is required. To meet this requirement, a silicon dioxide film 5 covers the hole-defining wall of the polysilicon layer 3, and an insulating film 22 covers the inner periphery of the silicon dioxide film 5. The insulating film 22 covers the hole-defining wall of the silicon nitride layer 4, too. The polysilicon T-like element 8 as insulated from the polysilicon layer 3 is in contact with the emitter region 10. In contact with the polysilicon T-like element 8 is the polysilicon T-like element 9. The polysilicon T-like element 9 is in contact with the contact-making metal 15 via the barrier metal 14.

The first conduction type may be either n-type or p-type. If the first conduction type is n-type, the second conduction type is p-type. If the first conduction type is p-type, the second conduction type is n-type. In the illustrated example, the first conduction type is n-type and the second conduction type is p-type.

With continuing reference to Figure 1, the substrate 1 is a silicon substrate doped with phosphorous (P) that is a n-type dopant. Phosphorous concentration is $2.0 \times 10^{17}/cm^3$. This value of concentration has been determined through various experiments as providing a high collector-emitter breakdown voltage as well as low collector resistance. It is necessary that the substrate 1 have phosphorous concentration of $2.0 \times 10^{17}/cm^3$ at least that portion of the substrate 1 which is in contact with the intrinsic base region 6. It is not always necessary, however, that the substrate 1 has the same phosphorous concentration of $2.0 \times 10^{17}/cm^3$ everywhere.

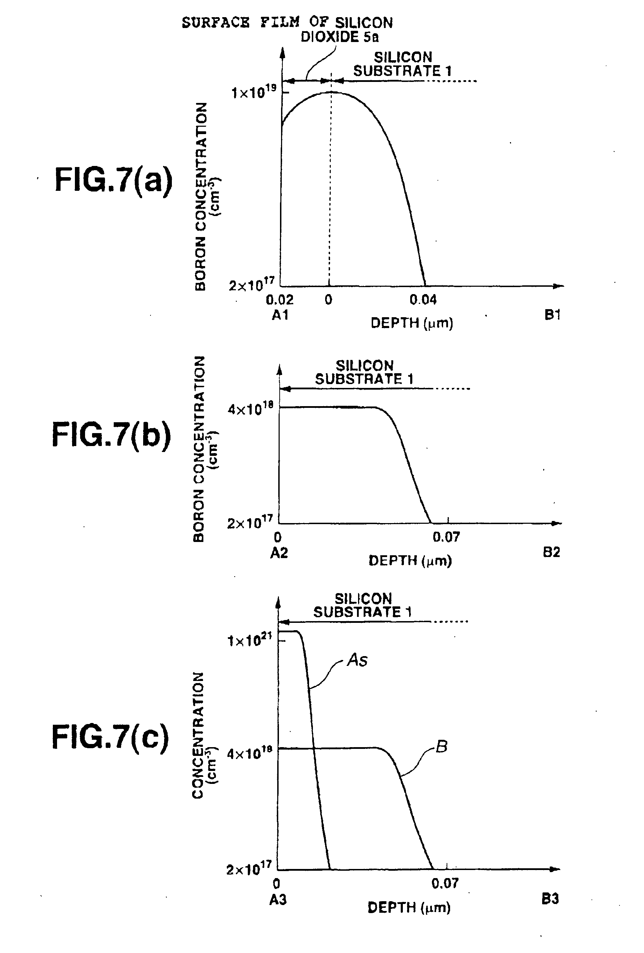

As mentioned before, the substrate 1 has the intrinsic base region 6 formed near the upper side surface thereof. The intrinsic base region 6 is doped with boron (B), a p-type dopant, to form a boron distribution layer. Referring to Figure 7(c), this layer is 0.062 μm thick. The boron concentration is $4.0 \times 10^{18}/cm^3$. The boron profile is of the box type. The buried emitter region 10 is formed into the upper portion of this born distribution layer. The emitter region 10 is 0.020 μm thick. Subtracting 0.020 μm (the thickness of the emitter region) from 0.062μm (the thickness of the boron distribution layer) gives 0.042 μm as the thickness of the intrinsic base region 6. In Figure 7(c), the thickness of boron distribution layer is defined as depth where boron concentrations are higher than a predetermined concentration value of $2 \times 10^{17}/cm^3$. This predetermined concentration value has been set equal to the concentration of phosphorous of $2 \times 10^{17}/cm^3$ within the adjacent collector region. A predetermined depth of 0.07 μm represents a threshold value of thickness of boron profile. This value has been determined after experiments.

The intrinsic base region 6 is in contact with and surrounded by the graft base 7. The graft base 7 is formed into the silicon substrate 1. The thickness of the graft base 7 is greater than the thickness of the intrinsic base region 6, and the former extends deeper than the latter does. The boron concentration of the graft base 7 is $1.0 \times 10^{20}/cm^3$.

Formed into and enclosed by the intrinsic base 6 is the emitter region 10. The emitter region 10 is doped with arsenic, a n-type dopant, to form an arsenic distribution layer. Referring to Figure 7(c), this layer is 0.02 μm thick. The arsenic concentration is $1.0 \times 10^{21}/cm^3$.

The emitter region 10 may be completely embedded into or elevated from the surface of the silicon substrate 1. The arsenic concentration of the emitter region 10 is far higher than the boron concentration of the intrinsic base region 6, causing flow of carrier from the emitter region 10 to the intrinsic base region 6. As compared to this flow of carrier, flow of carrier from the emitter region 10 toward the graft base 7 is difficult because the distance from the emitter region 10 to the graft base 7 is greater than the thickness of the intrinsic base region 6. If desired, the difficulty in flow of carrier may be increased by increasing the thickness of the insulating film 22 in a manner to depart the graft base 7 away from the emitter region 10. In this case, an increase in emitter-base breakdown voltage may be obtained.

The graft base 7, which surrounds the intrinsic base region 6, has an annular surface in contact with the polysilicon layer 3 doped with boron. The polysilicon layer 3 is in contact with the annular surface at the inner periphery portion thereof, leaving the outer periphery portion thereof uncovered. This uncovered outer periphery portion is covered by the silicon dioxide layer 2. The silicon dioxide layer 2 is formed to cover the surface of the silicon substrate 1, but it has been removed to leave the emitter region 10, the intrinsic base region 6, and the inner peripheral portion of the annular surface of the graft base 7 uncovered. The polysilicon layer 3 covers the inner peripheral portion of the annular surface of graft base 7, but it has been removed to leave the emitter region 10, and the intrinsic base region 6 uncovered.

Formed on the polysilicon layer 3 and the silicon dioxide layer 2 is the silicon nitride layer 4. The silicon nitride layer 4 has been partially removed to leave the emitter region 10 and the intrinsic base region 6 uncovered. As the polysilicon layer 3 and the silicon nitride layer 4 have been partially removed, the vertical hole is naturally formed to uncover the emitter region 10 and the intrinsic base region 6. Within this vertical hole, the silicon dioxide film 5 is formed to cover the hole-defining wall of the polysilicon layer 3, and the insulating film 22 is formed to cover the hole-defining wall of the silicon nitride layer 4 and the inner peripheral wall of the silicon dioxide film 5. The insulating film 22 is made of insulating material such as silicon dioxide, silicon nitride, and aluminium oxide. In this embodiment, the insulating film 22 of silicon nitride is used.

The vertical hole is filed with the polysilicon T-like elements 8 and 9. The polysilicon T-like elements 8 and 9 have laterally extending flange portions overlying one on the other. The flange portions of the polysilicon T-like elements 9 and 8 are superimposed one on top of the other and they coextend. However, coextending these flange portions is not always necessary. The flange portion of the polysilicon T-like element 9 may extend less than the other flange portion does. The polysilicon T-like elements 9 and 8 are both doped with n-type dopant. For better conduction performance, the polysilicon T-like element 9 is more heavily doped with n-type dopant than the other polysilicon T-like element 8 is.

Formed on the silicon nitride layer 4 and the polysilicon T-like element 9 is the insulating layer 20. The insulating layer 20 is made of insulating material such as silicon dioxide, silicon nitride, aluminium oxide, and boron phosphorus silicate glass (BPSG). In this embodiment, the insulating layer 20 of BPSG is used because low temperature is sufficient for BPSG to make a flat layer covering differences in level.

For electrical connection to the emitter electrode 16, the insulating layer 20 is formed with a through hole to uncover a central portion of the flange portion of the polysilicon T-like element 9. The barrier metal 14 is formed on the hole-defining sidewall of the insulating layer 20 and the central portion of the flange portion of the polysilicon T-like element 9. The barrier metal 14 encloses the contact-making metal 15. The contact-making metal 15 has a surface as high as the surface of the insulating layer 20. At this surface, the contact-making metal 15 is in contact with the emitter electrode 16. The emitter electrode 16 extends to cover the through hole filled with the contact-making metal 15.

For electrical connection to the base electrode 13, the insulating layer 20 and the silicon nitride layer 4 are formed with a through hole to uncover a portion of the polysilicon layer 3. The barrier metal 11 is formed on the hole-defining sidewalls of the insulating layer 20 and the silicon nitride layer 4, and the uncovered portion of the polysilicon layer 3. The barrier metal 11 encloses the contact-making metal 12. The contact-making metal 12 has a surface as high as the surface of the insulating layer 20. At this surface, the contact-making metal 12 is in contact with the base electrode 13. The base electrode 13 extends to cover the through hole filled with the contact-making metal 12.

For electrical connection to the collector electrode 19, the insulating layer 20, the silicon nitride layer 4, and the silicon dioxide layer 2 are formed with a through hole to uncover a portion of the silicon substrate 1. The barrier metal 17 is formed on the hole-defining sidewalls of the insulating layer 20, the silicon nitride layer 4, and the silicon dioxide layer 2, and the uncovered portion of the silicon substrate 1. The barrier metal 17 encloses the contact-making metal 18. The contact-making metal 18 has a surface as high as the surface of the insulating layer 20. At this surface, the contact-making metal 18 is in contact with the collector electrode 19. The collector electrode 19 extends to cover the through hole filled with the contact-making metal 18.

The barrier metal 11, 14, and 17 is made of a material such as nitride of titanium or tungsten or transition metal, boride of titanium or tungsten or transition metal, carbide of titanium or tungsten or transition metal, and silicide of titanium or tungsten or transition metal. In this embodiment, barrier metal of titanium/titanium nitride is used. The contact-making metal 12, 15 and 18 is made of a material such as titanium and tungsten. In this embodiment, the contact-making metal of tungsten is used. The electrode 13, 16, and 19 is made of a material such as gold, silver, aluminum, alloy of aluminum and barrier metal, alloy of aluminum, copper, and silicon, and alloy of copper, gold, and barrier metal. In this embodiment, the electrode of alloy of aluminum, copper, and silicon is used.

Let us discuss on what have to be considered with respect to the intrinsic base region 6. Increasing the cutoff frequency is necessary to extend range of frequency at which a bipolar transistor operates toward high frequencies. In order to increase the cutoff frequency, it is important to shorten the time required for electrons to pass through a base region for increased responsiveness by reducing the thickness of the base region than ever. Flatly reducing the thickness of the base region, however, would result in increased resistivity. To suppress such an increase in resistivity, increasing dopant concentration within the base region is necessary. Taking boron as the dopant or impurity of the base region, increasing the boron concentration is required. However, excessively increasing the boron concentration causes an increase the flow of hole current from base to emitter regions, resulting in a drop in current amplification. Thus, appropriate value of boron concentration exits within the base region. In order to provide stable operation with a thinner base region than ever, even distribution of boron concentration over the whole area of the base region is desired. Also desired is a boron profile that drops steeply near the boundary between base and collector regions.

From the above description, it will be understood that a desired boron profile within an intrinsic base region possesses the following property;

Reduced thickness (or depth);

Heavy boron concentration at an appropriate level; and

Even distribution of boron concentration, but a steep drop near the boundary (boron profile of the box type).

The desired boron profile is further described. The thickness (or depth) of boron doped layer is less than or equal to 0.07 µm. With regard to appropriate level of dopant concentration, the maximum N level of the dopant concentrations can be expressed as follows:

$$3.0 \times 10^{18}/cm^3 < N < 5.0 \times 10^{18}/cm^3.$$

With respect to the boron profile of the box type, over at least 70 % of the thickness of the profile, the difference between boron concentration and the maximum N falls in 10 % of the maximum N. The thickness of the boron profile is defined by the thickness of a range where the boron concentration is greater than or equal to $2 \times 10^{17}/cm^3$.

Applying the above-mentioned requirements to a bipolar transistor formed from the boron doped layer. In forming the bipolar transistor, an arsenic doped emitter region having 0.02 μm thick is formed into the boron doped layer. Thus, the intrinsic base region is less than or equal to 0.05 μm (= 0.07 μm - 0.02 μm). The maximum level N of the appropriate boron concentrations remains unaltered. With respect to the boron profile of the box type, over at least 60 % of the thickness of the profile, the difference between boron concentration and the maximum N falls in 10 % of the maximum N.

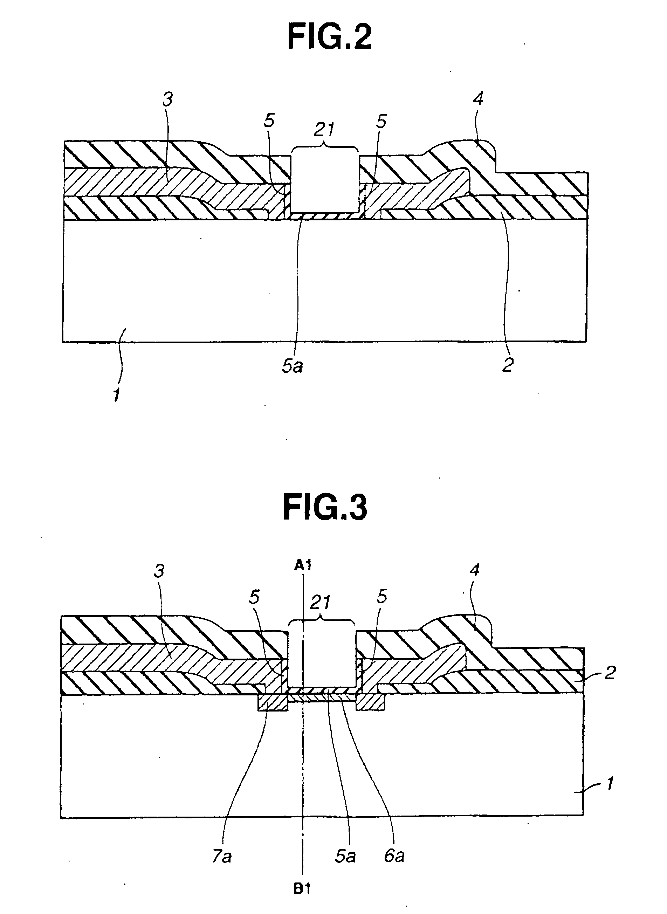

Referring to Figures 2 to 7(c), the present processing sequence according to the preferred embodiment is described.

In Figure 2, phosphorous doped silicon substrate 1 (phosphorous concentration of $2.0 \times 10^{17}/cm^3$) has arranged thereon a layer structure. The layer structure includes silicon dioxide layer 2, polysilicon layer 3, silicon nitride layer 4, silicon dioxide film 5, and a surface film 5a of silicon dioxide. The silicon dioxide layer 2 is formed on the silicon substrate 1 by thermal oxidation process, and subsequently selectively etch removed, by photo-etching process, to expose that portion of the silicon substrate 1 which is used to form a base region and an emitter region. The boron doped polysilicon layer 3 is formed by chemical vapor deposition (CVD) and subsequently selectively etch removed, by photo-etching process, to expose that portion of the silicon dioxide 2 which is used to arrange collector electrode 19. Subsequently, the silicon nitride layer 4 is formed by CVD. The boron doped polysilicon layer 3 and the silicon nitride layer 4 are selectively etch removed, by photo-etching process, to expose that portion of the silicon substrate 1 which is used to form base and emitter regions, thus forming an aperture or hole 21. It is to be noted that the portion of the boron doped polysilicon layer 3, which is to be in contact with graft base 7, is not removed. The silicon dioxide film 5 and the surface film 5a of silicon dioxide are formed by thermal oxidation process. The silicon dioxide film 5 extends to define the sidewall of the hole 21, while the surface film 5a of silicon dioxide defines the bottom of the hole 21. The processing sequence thus far described is conventionally used in fabricating bipolar transistors.

In the case where the phosphorus concentration of the silicon substrate 1 is less than the level of $2.0 \times 10^{17}/cm^3$, it is necessary to form a collector region that has phosphorus concentration as high as $2.0 \times 10^{17}/cm^3$. In this case, phosphorous ions are doped into the silicon substrate 1 through the surface film 5a by ion implantation. Phosphorous ions P are implanted. Ion energy is from 280 KeV to 320 KeV. Ion doze is from $4 \times 10^{12}/cm^2$ to $6 \times 10^{12}/cm^2$. The ion implantation is followed by anneal to restore the damage and diffuse the implanted ions. This technique is conventionally used in fabricating bipolar transistors.

With reference to Figure 3, boron ions are doped into the silicon substrate 1 by ion implantation through the surface film 5a of silicon dioxide. Molecular ions $^{49}(BF_2)^+$ are implanted. Ion energy is from 3 KeV to 5 KeV. Ion dose is from $1 \times 10^{15}/cm^2$ to $1.5 \times 10^{15}/cm^2$. The ion implantation is followed by an initial anneal to restore lattice disorder. This initial anneal is performed by a lamp anneal. This lamp anneal is done within nitrogen atmosphere at annealing temperature of from 850°C to 950°C for 10 seconds to 60 seconds. With this initial anneal, the implanted boron ions within the silicon substrate 1 are diffused to form intrinsic base region 6a and graft base 7a. Figure 7(a) shows the boron profile across the surface film 5a and the intrinsic base region 6a along the line A1-B1 through the intermediate structure shown in Figure 3.

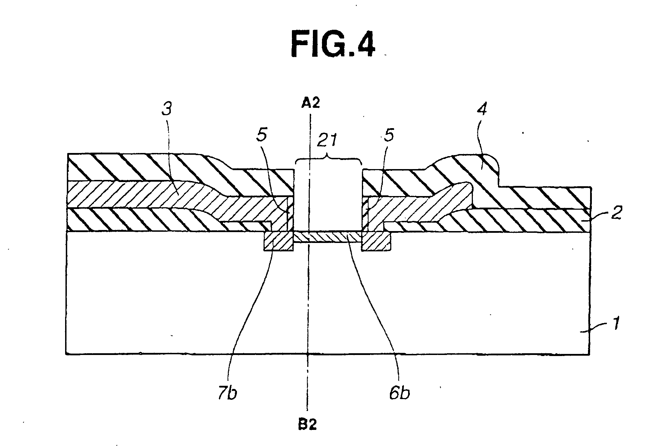

With reference now to Figure 4, after the surface film 5a of silicon dioxide has been removed, an anneal is done. This second stage anneal is a lamp anneal. This lamp anneal is done within nitrogen atmosphere at annealing temperature of from 850°C to 950°C for 10 seconds to 60 seconds. During this lamp anneal, boron concentration near the surface of the silicon substrate 1 drops due to escape or diffusion of boron out of the silicon substrate 1. Owing to the escape of boron out of the silicon substrate, diffusion of unnecessary amount of boron into the silicon substrate is effectively avoided. At annealing temperature of 900°C, implanted boron out of concentrations higher than $3 \times 10^{18}/cm^3$ is diffused deeply into the silicon substrate 1 due to electric field promotion effect, leaving implanted boron out of lower concentrations as being little diffused. Thus, the intrinsic base region and the graft base have grown deeply to the illustrated base region and graft base 6b and 7b, respectively. Figure 7(b) shows a box type boron profile across the base region 6b along the line A2-B2 through the intermediate structure shown in Figure 4.

Referring to the boron profile shown in Figure 7(b), the thickness in the depth direction is 0.062 μm and thus less than 0,07 μm, and the maximum level of the boron concentration is around $4 \times 10^{18}/cm^3$. Besides, over 70 % of the thickness in the depth direction, the difference between the boron concentrations and the maximum level N falls in 10 % of the maximum level. In this manner, the boron profile of the desired box type is obtained. This boron profile has been obtained by removing the boron doped surface film 5a before the anneal, and allowing escape of dopant out of the silicon substrate 1 into the ambient nitrogen atmosphere during annealing. In other words, during annealing after removing the boron doped surface film 5a, there is no supply of dopant from the surface film 5a, and escape of dopant toward the ambient nitrogen atmosphere is facilitated. As a result, the amount of implanted boron diffusing deeply into the silicon substrate 1 is considerably reduced.

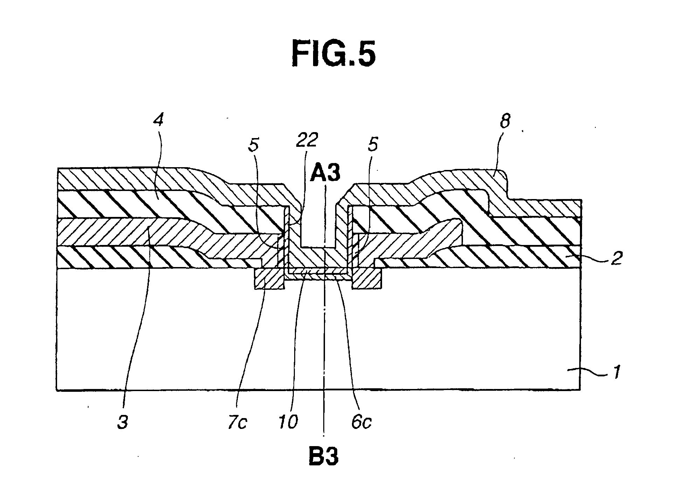

With reference next to Figure 5, insulating film 22 is formed to cover the sidewall of the hole above the boron doped layer by photo-etching process. Polysilicon T-like element 8 is formed and doped with arsenic by ion implantation. Subsequently, anneal is carried out to form emitter region 10. This anneal is a lamp anneal.

This lamp anneal is done within nitrogen atmosphere at annealing temperature of 950°C for 5 seconds to 20 seconds. During this annealing, the implanted arsenic ions are diffused into the intrinsic base region 6b. In this manner, the emitter region 10 is formed into the intrinsic base region 6b at a portion near the boundary with the polysilicon T-like element 8. The boron profile within the intrinsic base 6b is unaltered during the diffusion of arsenic ions. Figure 7(c) shows boron and arsenic profiles across the emitter region 10 and the intrinsic base region 6c along the line A3-B3 through the intermediate structure shown in Figure 5.

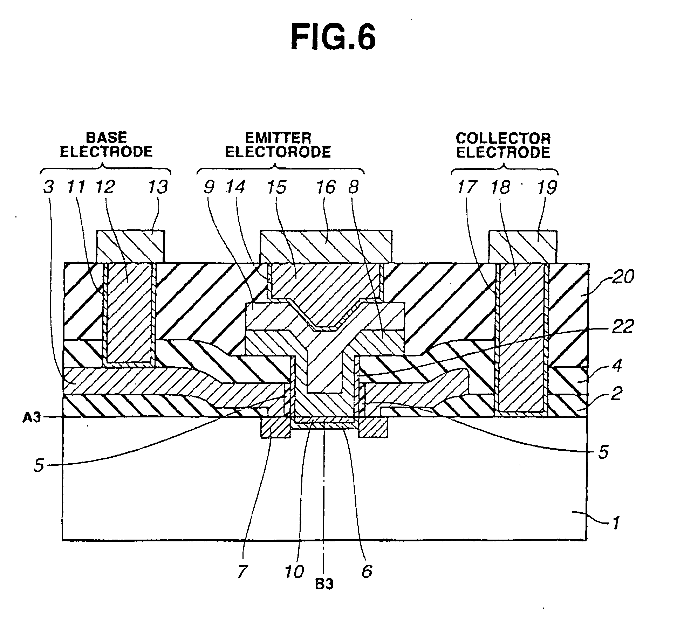

As shown in Figure 6, the silicon substrate 1, intrinsic base region 6, and emitter region 10 are routed electrically outwards via collector electrode 19, base electrode 13, and emitter electrode 16, respectively.

Cutoff frequency and early voltage have been measured on the bipolar transistor fabricated by the above-mentioned processing steps. The cutoff frequency $f_T$ is 42.6 GHz at collector-emitter voltage $V_{ce} = 1$ V. Early voltage is 11 V.

It will be noted that dopant profiles shown in Figure 7(c) clearly show that the desired boron profile of the intrinsic base region of a bipolar transistor has been accomplished.

Referring to Figures 2 to 7(c), processing sequence according to the second preferred embodiment will be described.

The processing sequence according to the second preferred embodiment is substantially the same as the processing sequence according to the first preferred embodiment. However, the former is different from the latter in the manner of forming the surface film 5a of silicon dioxide. According to the second preferred embodiment, the surface film 5a is formed during formation of silicon dioxide 2. The second embodiment is different from the first embodiment in the process of anneal after removing the surface film 5a. In the second preferred embodiment, the anneal after removal of the surface film 5a is carried out by a furnace anneal. The furnace anneal is done within nitrogen atmosphere at annealing temperature of from 800°C to 900°C for 5 minutes to 10 minutes.

In the preferred embodiments, the present invention has been described in connection with a bipolar transistor. The present invention is not limited to this. The present invention may be applicable to MOS transistor, diode, and other elements where dopant profile of the box type is needed.

While the present invention has been particularly described, in conjunction with the preferred embodiments, it is evident that many alternatives, modifications and variations will be apparent to those skilled in the art in light of the foregoing description. It is therefore contemplated that the appended claims will embrace any such alternatives, modifications and variations as falling within the true scope and spirit of the present invention.

**Claims**

1. A semiconductor device, comprising:

   a semiconductor substrate having a collector region doped with a first dopant; and
   a base region formed into the substrate and has a thickness, in depth direction, that is less than or equal to 0.05 μm, the base region being doped with a second dopant and having a dopant profile,
   the dopant profile having dopant concentrations whose maximum level (N) is greater than $3.0 \times 10^{18}/cm^3$ and less than $5.0 \times 10^{18}/cm^3$, over at least 60 % of the thickness of the base region, the difference between the dopant concentrations and the maximum level (N) falling in 10 % of the maximum level (N),
   the thickness of the base region being the depth of a range where the dopant concentrations are greater than or equal to a dopant concentration of the first dopant of the collector region.

2. A semiconductor device, comprising:

   a semiconductor substrate; and
   a base region formed into the substrate and has a thickness, in depth direction, that is less than or equal to 0.05 μm, the base region being doped with a second dopant and having a dopant profile,
   the dopant profile having dopant concentrations whose maximum level (N) is greater than $3.0 \times 10^{18}/cm^3$ and less than $5.0 \times 10^{18}/cm^3$, over at least 60 % of the thickness of the base region, the difference between the dopant concentrations and the maximum level (N) falling in 10 % of the maximum level (N),
   the thickness of the base region being the depth of a range where the dopant concentrations are greater than or equal to a dopant concentration value of $2 \times 10^{17}/cm^3$.

3. A process for fabricating semiconductor devices, comprising:

   forming a surface film on the surface of a semiconductor substrate;
   doping the semiconductor substrate with dopant through the surface film to form a dopant distribution layer;
   removing the surface film doped with the dopant; and
   annealing the semiconductor substrate after the removing of the surface film.

4. The process as claimed in claim 3, further comprising:

annealing the semiconductor substrate with the surface film before the removing of the surface film.

5. The process as claimed in claim 3,

wherein the semiconductor substrate is formed with a region adjacent to the dopant distribution layer;

wherein the thickness in the depth direction of the dopant distribution layer is less than 0.07 $\mu$m; and

wherein the thickness of the dopant distribution layer is the depth of a range where the dopant concentrations are greater than or equal to a dopant concentration of the adjacent region within the semiconductor substrate.

6. The process as claimed in claim 4,

wherein the semiconductor substrate is formed with a region adjacent to the dopant distribution layer;

wherein the thickness in the depth direction of the dopant distribution layer is less than 0.07 $\mu$m; and

wherein the thickness of the dopant distribution layer is the depth of a range where the dopant concentrations are greater than or equal to a dopant concentration of the adjacent region within the semiconductor substrate.

7. The process as claimed in claim 3,

wherein the thickness in the depth direction of the dopant distribution layer is less than 0.07 $\mu$m; and

wherein the thickness of the dopant distribution layer is the depth of a range where the dopant concentrations are greater than or equal to a dopant concentration value of $2 \times 10^{17}/cm^3$.

8. The process as claimed in claim 4,

wherein the thickness in the depth direction of the dopant distribution layer is less than 0.07 $\mu$m; and

wherein the thickness of the dopant distribution layer is the depth of a range where the dopant concentrations are greater than or equal to a dopant concentration value of $2 \times 10^{17}/cm^3$.

9. The process as claimed in claim 3,

wherein the dopant distribution layer has a dopant profile, the dopant profile having dopant concentrations whose maximum level (N) is greater than $3.0 \times 10^{18}/cm^3$ and less than $5.0 \times 10^{18}/cm^3$,

over at least 70 % of the thickness of the dopant distribution layer, the difference between the dopant concentrations and the maximum level (N) falling in 10 % of the maximum level (N).

10. The process as claimed in claim 4,

wherein the dopant distribution layer has a dopant profile, the dopant profile having dopant concentrations whose maximum level (N) is greater than $3.0 \times 10^{18}/cm^3$ and less than $5.0 \times 10^{18}/cm^3$,

over at least 70 % of the thickness of the dopant distribution layer, the difference between the dopant concentrations and the maximum level (N) falling in 10 % of the maximum level (N).

11. The process as claimed in claim 5,

wherein the dopant distribution layer has a dopant profile, the dopant profile having dopant concentrations whose maximum level (N) is greater than $3.0 \times 10^{18}/cm^3$ and less than $5.0 \times 10^{18}/cm^3$,

over at least 70 % of the thickness of the dopant distribution layer, the difference between the dopant concentrations and the maximum level (N) falling in 10 % of the maximum level (N).

12. The process as claimed in claim 6,

wherein the dopant distribution layer has a dopant profile, the dopant profile having dopant concentrations whose maximum level (N) is greater than $3.0 \times 10^{18}/cm^3$ and less than $5.0 \times 10^{18}/cm^3$,

over at least 70 % of the thickness of the dopant distribution layer, the difference between the dopant concentrations and the maximum level (N) falling in 10 % of the maximum level (N).

13. The process as claimed in claim 7,

wherein the dopant distribution layer has a dopant profile, the dopant profile having dopant concentrations whose maximum level (N) is greater than $3.0 \times 10^{18}/cm^3$ and less than $5,0 \times 10^{18}/cm^3$,

over at least 70 % of the thickness of the dopant distribution layer, the difference between the dopant concentrations and the maximum level (N) falling in 10 % of the maximum level (N).

14. The process as claimed in claim 8,

wherein the dopant distribution layer has a dopant profile, the dopant profile having dopant concentrations whose maximum level (N) is greater than $3.0 \times 10^{18}/cm^3$ and less than $5.0 \times 10^{18}/cm^3$,

over at least 70 % of the thickness of the dopant distribution layer, the difference between the dopant concentrations and the maximum level (N) falling in 10 % of the maximum level (N),

15. The process as claimed in claim 3, wherein the annealing step is done within inert gas atmosphere.

16. The process as claimed in claim 4, wherein at least one of the annealing steps is done within inert gas atmosphere.

17. The process as claimed in claim 3, wherein annealing temperature of the annealing step is higher than or equal to 860°C but lower than or equal to 950°C.

18. The process as claimed in claim 4, wherein annealing temperature of at least one of the annealing steps is higher than or equal to 800°C but lower than or equal to 950°C.

19. The process as claimed in claim 3, wherein the annealing step is done for a period of time longer than or equal to 5 seconds but shorter than or equal to 20 minutes.

20. The process as claimed in claim 4, wherein at least one of the annealing steps is done for a period of time longer than or equal to 5 seconds but shorter than or equal to 20 minutes.

21. The process as claimed in claim 3, wherein the surface film is made of an insulating layer.

22. The process as claimed in claim 21, wherein the insulating layer is made of one of silicon dioxide and silicon nitride.

23. The process as claimed in claim 3, wherein an intrinsic base region of a bipolar transistor is formed from the dopant distribution layer.

24. The process as claimed in claim 3, wherein the annealing step is done by a lamp anneal within nitrogen atmosphere at annealing temperature of from 850°C to 950°C for 10 seconds to 60 seconds.

25. The process as claimed in claim 3, wherein the annealing step is done by a furnace anneal within nitrogen atmosphere at annealing temperature of from 800°C to 900°C for 5 minutes to 10 minutes.

26. A process for fabricating semiconductor devices, comprising:

    forming a surface film on the surface of a semiconductor substrate;
    doping, by ion implantation, the semiconductor substrate with dopant through the surface film to form a dopant distribution layer;
    removing the surface film doped with the dopant;
    annealing the semiconductor with the surface film by a lamp anneal within nitrogen atmosphere at annealing temperature of from 850°C to 950° for 10 seconds to 60 seconds;
    removing the surface film doped with the dopant;
    annealing the semiconductor substrate after the removing of the surface film by a lamp anneal within nitrogen atmosphere at annealing temperature of from 850°C to 950° for 10 seconds to 60 seconds.

27. A process for fabricating semiconductor devices, comprising:

    forming a surface film on the surface of a semiconductor substrate;
    doping, by ion implantation, the semiconductor substrate with dopant through the surface film to form a dopant distribution layer;
    removing the surface film doped with the dopant;
    annealing the semiconductor with the surface film by a lamp anneal within nitrogen atmosphere at annealing temperature of from 850°C to 950° for 10 seconds to 60 seconds;
    removing the surface film doped with the dopant;
    annealing the semiconductor substrate after the removing of the surface film by a furnace anneal within nitrogen atmosphere at annealing temperature of from 800°C to 900° for 5 minutes to 10 minutes.

# FIG.1

# FIG.2

# FIG.3

# FIG.4

# FIG.5

# FIG.6

FIG.7(a)

SURFACE FILM OF SILICON DIOXIDE 5a

SILICON SUBSTRATE 1

BORON CONCENTRATION (cm⁻³)

$1 \times 10^{19}$

$2 \times 10^{17}$

0.02   0   0.04

A1   DEPTH (μm)   B1

FIG.7(b)

SILICON SUBSTRATE 1

BORON CONCENTRATION (cm⁻³)

$4 \times 10^{18}$

$2 \times 10^{17}$

0   0.07

A2   DEPTH (μm)   B2

FIG.7(c)

SILICON SUBSTRATE 1

CONCENTRATION (cm⁻³)

$1 \times 10^{21}$

As

$4 \times 10^{18}$

B

$2 \times 10^{17}$

0   0.07

A3   DEPTH (μm)   B3

16

# FIG.8

103    105    105    104

105a    102

101

# FIG.9

C1

103    105    105    104

102

101

107a    105a 106a

D1

# FIG.10

FIG.11(a)

THIRD SILICON
DIOXIDE 105a

SILICON
SUBSTRATE 101

BORON CONCENTRATION (cm⁻³)

$1 \times 10^{19}$

$2 \times 10^{17}$

0.02
C1

0

0.04

D1

DEPTH (μm)

FIG.11(b)

THIRD SILICON
DIOXIDE 105a

SILICON
SUBSTRATE 101

BORON CONCENTRATION (cm⁻³)

$4 \times 10^{18}$

$2 \times 10^{17}$

0.02
C2

0

0.07

D2

DEPTH (μm)